# EUROPEAN PATENT APPLICATION

(11) **EP 4 489 544 A1**
(43) Date of publication of application: **08.01.2025**
(21) Application number: 24186207.7
(22) Date of filing: 03.07.2024
(51) Int. Cl.: H10B 12/00

(54) **SEMICONDUCTOR DEVICE**

(30) Priority: 05.07.2023 KR 20230087134
(71) Applicant: Samsung Electronics Co., Ltd, Suwon-si, Gyeonggi-do 16677 (KR)
(72) Inventor: LEE, Choonghyun, 16677 Suwon-si (KR); KIM, Kanguk, 16677 Suwon-si (KR); KIM, Jooncheol, 16677 Suwon-si (KR); KIM, Jina, 16677 Suwon-si (KR)
(74) Representative: Marks & Clerk LLP

(57) **Abstract**

A semiconductor device is provided. The semiconductor device includes a first bit line crossing a memory cell array region in a first direction and extending into an extension region adjacent to the memory cell array region, a second bit line crossing the memory cell array region in the first direction and extending into the extension region, and adjacent to the first bit line, an insulating pattern within the extension region and contacting an end portion of the second bit line in the first direction, and an insulating spacer within the extension region and contacting an end portion of the first bit line in the first direction, the insulating spacer being different from the insulating pattern.

## Description

### BACKGROUND

Example embodiments relate to semiconductor devices and/or methods for manufacturing the semiconductor device.

Research is being conducted to reduce the size of elements constituting semiconductor devices and to improve performance. For example, in DRAM, research is being conducted to reliably and stably form elements having reduced sizes.

### SUMMARY

Some example embodiments provide semiconductor devices for increasing a degree of integration.

Some example embodiments provide semiconductor devices for improving reliability.

Some example embodiments provide methods for manufacturing a semiconductor device for increasing a degree of integration and improving reliability.

According to an example embodiment, a semiconductor device includes a first bit line crossing a memory cell array region in a first direction, the first bit line extending into an extension region adjacent to the memory cell array region, a second bit line crossing the memory cell array region in the first direction, the second bit line extending into the extension region and adjacent to the first bit line. an insulating pattern within the extension region and contacting an end portion of the second bit line in the first direction, and an insulating spacer within the extension region and contacting an end portion of the first bit line in the first direction, the insulating spacer being different from the insulating pattern.

According to an example embodiment, a semiconductor device includes a substrate including a memory cell array region and an extension region, line structures crossing the memory cell array region and extending into the extension region, the line structures being parallel to each other, and insulating patterns within the extension region, and spaced apart from each other. Each of the line structures has a line shape extending in a first direction, the line structures include a first line structure and second line structures on both sides of the first line structure, the insulating pattern contact end portions of the second line structures in the first direction within the extension region, and within the extension region, an end portion of the first line structure in the first direction is between the insulating patterns.

According to an example embodiment, a semiconductor device includes a substrate including a memory cell array region, a first extension region, and a second extension region, bit line structures crossing the memory cell array region and extending into the first extension region and the second extension region, the bit line structures being parallel to each other on the substrate, first insulating patterns within the first extension region, the first insulating patterns spaced apart from each other on the substrate, and second insulating patterns within the second extension region, the second insulating patterns spaced apart from each other on the substrate, wherein the memory cell array region is between the first extension region and the second extension region, each of the bit line structures has a line shape extending in a first direction, the bit line structures include first bit line structures and second bit line structures alternating in a second direction perpendicular to the first direction, within the first extension region, the first insulating patterns contact end portions of the second bit line structures in the first direction, within the second extension region, the second insulating patterns contact end portions of the first bit line structures in the first direction, within the first extension region, the end portions of the first bit line structures in the first direction are between the first insulating patterns, and within the second extension region, the end portions of the second bit line structures in the first direction are between the second insulating patterns.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings:
FIGS. 1 to 3E are views illustrating a semiconductor device according to an example embodiment;
FIG. 4 is a plan view illustrating a modified example of a semiconductor device according to an example embodiment;
FIGS. 5A and 5B are views illustrating a modified example of a semiconductor device according to an example embodiment;
FIGS. 6 and 7 are views illustrating a modified example of a semiconductor device according to an example embodiment;
FIGS. 8 and 9 are views illustrating a modified example of a semiconductor device according to an example embodiment;
FIGS. 10A and 10B are views illustrating a modified example of a semiconductor device according to an example embodiment;
FIG. 11 is a cross-sectional view illustrating a modified example of a semiconductor device according to an example embodiment; and
FIGS. 12 to 18C are views illustrating an example of a method for manufacturing a semiconductor device according to an example embodiment.

### DETAILED DESCRIPTION

Hereinafter, terms such as "upper," "intermediate," "lower," and the like, are replaced with other terms, such as "first," "second," "third," and the like, so the terms may be used to describe elements of the specification. Terms such as "first," "second," "third," and the like may be used to describe various elements, but the elements are not limited by the above terms, and "a first element" may be referred to as "a second element."

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

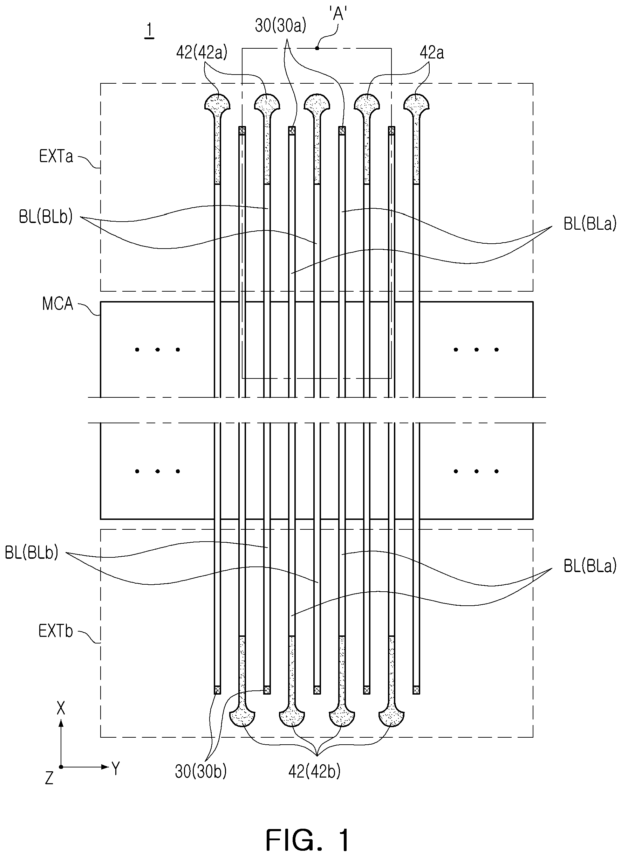

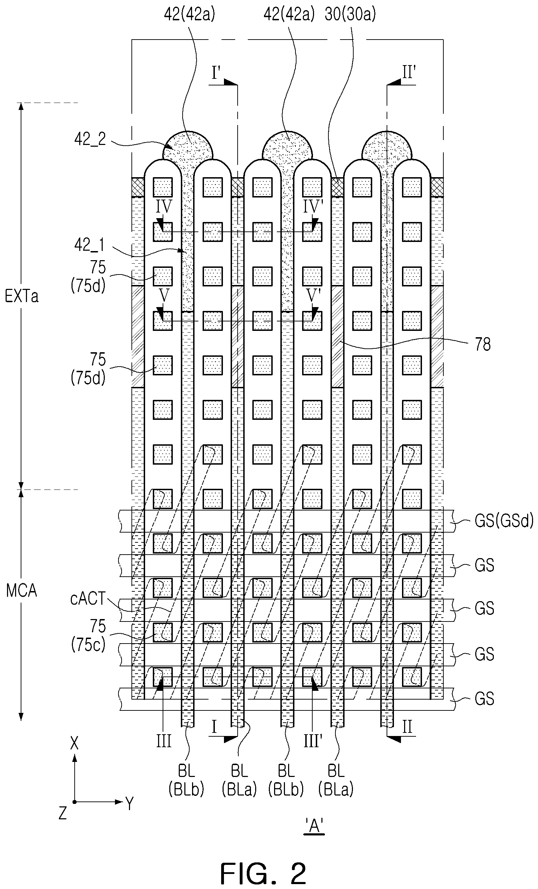

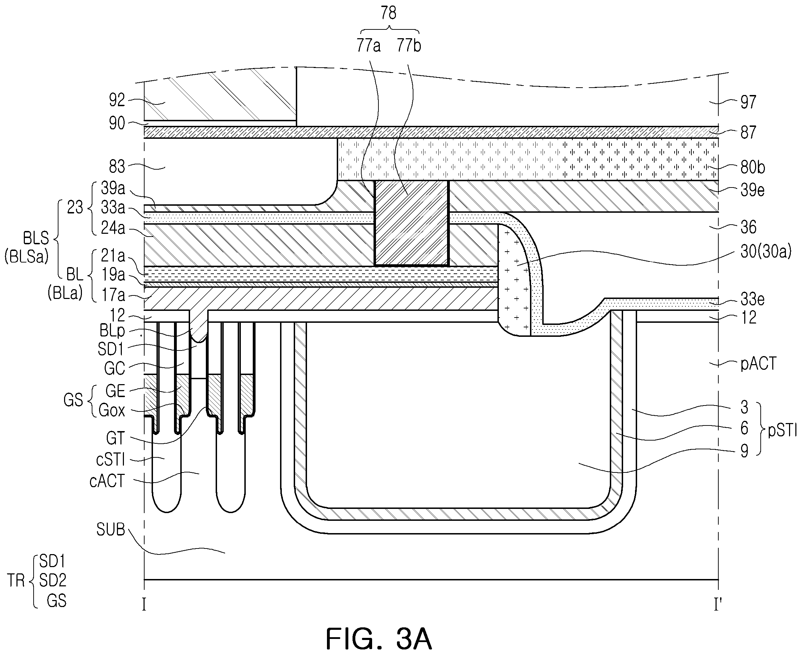

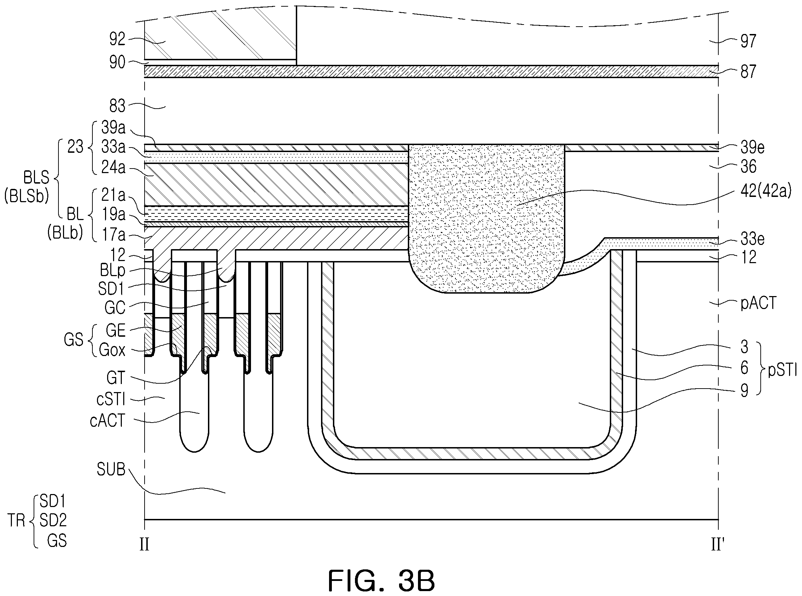

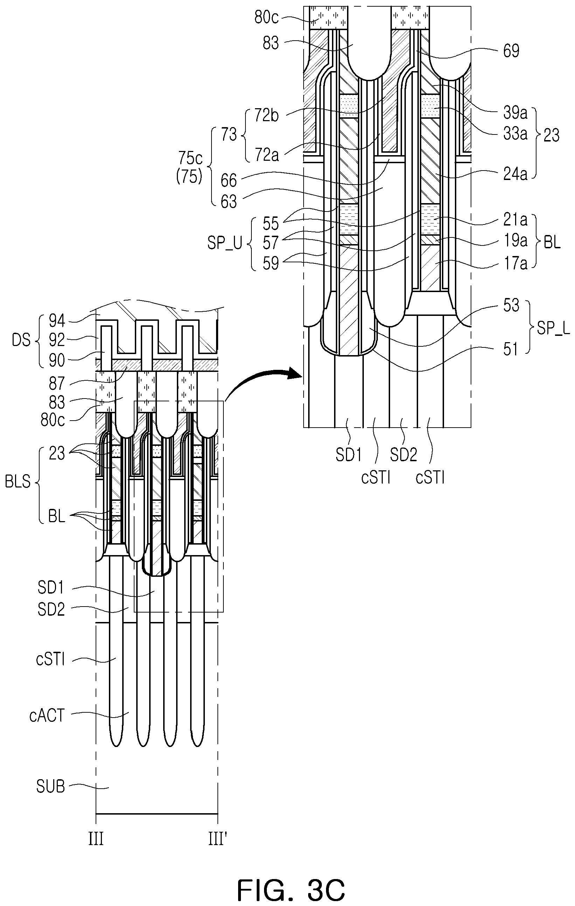

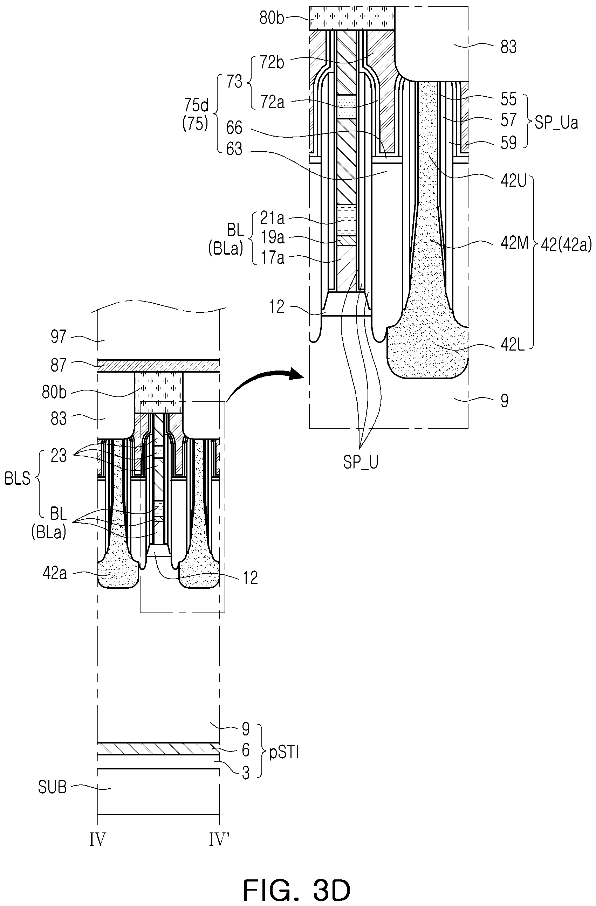

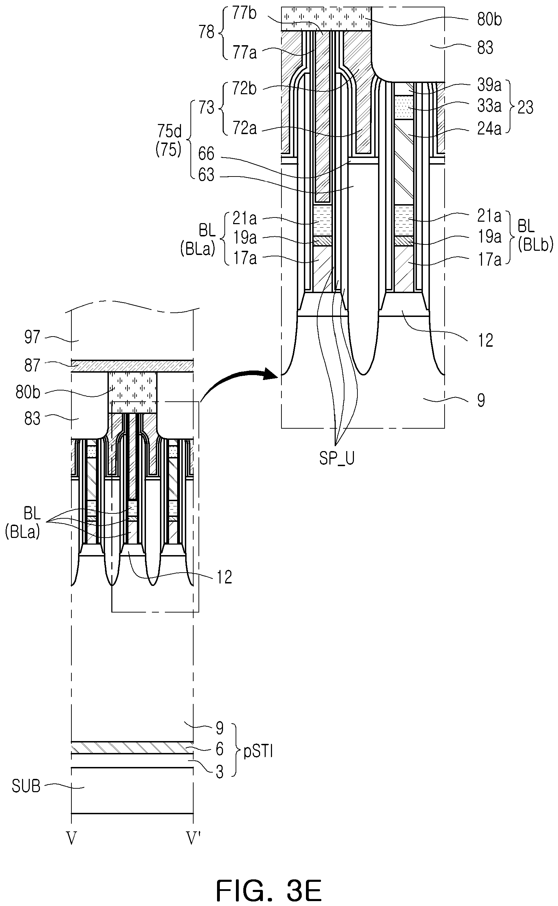

An example of a semiconductor device according to an example embodiment of the present inventive concepts will be described with reference to FIGS. 1 to 3E. FIGS. 1 to 3E are views illustrating a semiconductor device according to an example embodiment of the present inventive concepts, FIG. 1 is a plan view illustrating a semiconductor device according to an example embodiment of the present inventive concepts, FIG. 2 is a partially enlarged view of region 'A' in FIG. 1, FIG. 3A is a cross-sectional view taken along line I-I' of FIG. 2, FIG. 3B is a cross-sectional view taken along line II-II' of FIG. 2, FIG. 3C is a cross-sectional view taken along line III-III' in FIG. 2, FIG. 3D is a cross-sectional view taken along line IV-IV' in FIG. 2, and FIG. 3E is a cross-sectional view taken along line V-V' in FIG. 2.

Referring to FIGS. 1 to 3E, a semiconductor device 1 according to an example embodiment may include a memory cell array region MCA, a first extension region EXTa, and a second extension region EXTb. The first extension region EXTa and the second extension region EXTb may be adjacent to the memory cell array region MCA. The memory cell array region MCA may be a region in which memory cells for storing data are arranged. The memory cell array region MCA may be disposed between the first extension region EXTa and the second extension region EXTb.

The semiconductor device 1 may further include line structures BLS parallel to each other.

The line structures BLS may cross the memory cell array region MCA in a first direction X and extend into the first extension region EXTa. The line structures BLS may further include portions extending from the memory cell array region MCA to a second extension region EXTb. Accordingly, the line structures BLS may cross the memory cell array region MCA, and may extend into the first and second extension areas EXTa and EXTb.

Each of the line structures BLS may have a line shape extending in the first direction X. The line structures BLS may be spaced apart from each other in a second direction Y perpendicular to the first direction X.

The line structures BLS may include first line structures BLSa and second line structures BLSb alternately disposed in the second direction.

Each of the line structures BLS may include a conductive line BL and a capping pattern 23 on the conductive line BL. Accordingly, each of the first line structures BLSa may include the conductive line BL and the capping pattern 23, sequentially stacked, and each of the second line structures BLSb may include the conductive line BL and the capping pattern 23, sequentially stacked.

In some example embodiments, the conductive lines BL of the first line structures BLSa may be first conductive lines BLa, and the conductive lines BL of the second line structures BLSb may be second conductive lines BLb.

In some example embodiments, the conductive lines BL may be 'bit lines'. Hereinafter, the conductive lines BL will be referred to as 'bit lines' and will be described, the line structures BLS will be referred to as 'bit line structures' and will be described, the first conductive lines BLa will be referred to as 'first bit lines' and will be described, and the second conductive lines BLb will be referred to as 'second bit lines' and will be described.

Each of the bit lines BL may include at least one conductive material layer. For example, each of the conductive lines BL may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, graphene, carbon nanotubes, or a combination thereof, but example embodiments thereof are not limited thereto. Each of the bit lines BL may include a single layer or multiple layers of the above-described materials. For example, each of the bit lines BL may include a first conductive material layer 17a, a second conductive material layer 19a on the first conductive material layer 17a, and a third conductive material layer 21a on the second conductive material layer 19a. The first to third conductive material layers 17a, 19a, and 21a may include different materials.

The capping patterns 23 may include a first insulating material layer 24a, a second insulating material layer 33a on the first insulating material layer 24a, and a third insulating material layer 39a on the second insulating material layer 33a. In each of the capping patterns 23, a thickness of the second insulating material layer 33a may be less than that of each of the first and third insulating material layers 24a and 39a.

Each of the capping patterns 23 may include an insulating material such as silicon nitride. The capping patterns 23 may also be referred to as 'insulating capping patterns' or 'bit line capping patterns'.

The semiconductor device 1 may further include insulating patterns 42 contacting the bit line structures BLS.

The insulating patterns 42 may include first insulating patterns 42a disposed within the first extension region EXTa and second insulating patterns 42b disposed within the second extension region EXTb.

Within the first extension region EXTa, the first insulating patterns 42a may contact end portions of the second bit line structures BLSb in the first direction X located within the first extension region EXTa. Within the first extension region EXTa, the first insulating patterns 42a may contact end portions of the second bit lines BLb in the first direction X located within the first extension region EXTa. Within the first extension region EXTa, the first insulating patterns 42a may contact end portions of the second bit lines BLb in the first direction X located within the first extension region EXTa and the capping patterns 23.

Within the second extension region EXTb, the second insulating patterns 42b may contact end portions of the first bit line structures BLSa in the first direction X located within the second extension region EXTb. Within the second extension region EXTb, the second insulating patterns 42b may contact end portions of the first bit lines BLa in the first direction X located within the second extension region EXTb. Within the second extension region EXTb, the second insulating patterns 42b may contact end portions of the first bit lines BLa in the first direction (X) located within the second extension region EXTb and the capping patterns 23.

Within the first extension region EXTa, end portions of the first bit lines BLa may be disposed between the first insulating patterns 42a. In the second extension region EXTb, end portions of the second bit lines BLb may be disposed between the second insulating patterns 42b.

The second bit lines BLb and the first insulating patterns 42a may be sequentially arranged in the first direction (X). The first bit lines BLa and the second insulating patterns 42b may be sequentially arranged in the first direction (X).

The insulating patterns 42 may include the same material as at least one material of the capping patterns 23. Each of the insulating patterns 42 may include an insulating material such as silicon nitride.

Each of the insulating patterns 42 may include a first portion 42_1 extending in the first direction (X) and a second portion 42_2 extending from the first portion 42_1 and having a width greater than that of the first portion 42_1. The first portions 42_1 of the insulating patterns 42 may contact the bit lines BL, and may be disposed between the second portion 42_2 of the insulating patterns 42 and the bit lines BL. For example, within the first extension region EXTa, the first portions 42_1 of the first insulating patterns 42a may contact the second bit lines BLb, and may be disposed between the second portions 42_2 of the first insulating patterns 42a and the second bit lines BLb.

Within the first and second extension regions EXTa and EXTb, a width of each of the second portions 42_2 of the insulating patterns 42 may be greater than a width of each of the bit lines BL.

The insulating patterns 42 may mitigate or prevent defects of the bit line structures BLS from occurring within the first and second extension regions EXTa and EXTb. For example, within the first and second extension regions EXTa and EXTb, the insulating patterns 42 may serve to mitigate or prevent deformation of the bit line structures BLS (such as a bridge defect that might occur when the end portions of the bit lines are bent, or a defect that occurs when the end portions of the bit lines become thin). Therefore, even if the size of the bit line structures BLS is reduced for high integration of the semiconductor device 1, deformation of the bit line structures BLS may be mitigated or prevented by the insulating patterns 42.

The semiconductor device 1 may further include insulating spacers 30 contacting the bit line structures BLS in the first and second extension regions EXTa and EXTb.

The insulating spacers 30 may be spaced apart from the insulating patterns 42. Each of the insulating spacers 30 may include at least one insulating material layer. The insulating spacers 30 may include a material different from that of the insulating patterns 42. For example, the insulating patterns 42 may include silicon nitride, and the insulating spacers 30 may include at least one of silicon oxide or a low-x dielectric. The low-x dielectric may be a dielectric having a dielectric constant lower than that of silicon oxide.

The insulating spacers 30 may include first insulating spacers 30a disposed within the first extension region EXTa and second insulating spacers 30b disposed within the second extension region EXTb.

Within the first extension region EXTa, the first insulating spacers 30a may contact end portions of the first bit lines BLa located within the first extension region EXTa. Within the first extension region EXTa, the first insulating spacers 30a may contact end portions of the first bit lines BLa located within the first extension region EXTa and the capping patterns 23.

Within the second extension region EXTb, the second insulating spacers 30b may contact end portions of the second bit line structures BLSb located within the second extension region EXTb. Within the second extension region EXTb, the second insulating spacers 30b may contact end portions of the second bit lines BLb located within the second extension region EXTb. Within the second extension region EXTb, the second insulating spacers 30b may contact end portions of the second bit lines BLb located within the second extension region EXTb and the capping patterns 23.

Within the first extension region EXTa, end portions of the first bit line structures BLSa and the first insulating spacers 30a may be disposed between the first insulating patterns 42a. Within the second extension region EXTb, end portions of the second bit line structures BLb and the second insulating spacers 30b may be disposed between the second insulating patterns 42b.

Among the bit lines BL, the insulating patterns 42, and the insulating spacers 30 connected to each other, one bit line BL may be disposed between one insulating pattern 42 and one insulating spacer 30. For example, the one first bit line BLa may be connected to the one first insulating spacer 30a within the first extension region EXTa, and may be connected to the one second insulating pattern 42b within the second extension region EXTb. The one second bit line BLb may be connected to the one first insulating pattern 42a within the first extension region EXTa, and may be connected to the one second insulating spacer 30b within the second extension region EXTb. Accordingly, the one first bit line BLa may be disposed between the one first insulating spacer 30a and the one second insulating pattern 42b, and the one second bit line BLb may be disposed between the one first insulating pattern 42a and the one second insulating spacer 30b.

In the second direction Y, the insulating spacers 30 may have substantially the same width as the bit lines BL.

Lengths of the insulating patterns 42 in the first direction X may be greater than lengths of the insulating spacers 30 in the first direction X.

Within the first and second extension regions EXTa and EXTb, the insulating spacers 30 may serve to mitigate or prevent deformation of the bit line structures BLS.

The semiconductor device 1 may further include a substrate SUB, cell active regions cACT disposed on the substrate SUB within the memory cell array region MCA, cell device isolation region cSTI disposed on side surfaces of the cell active regions cACT within the memory cell array region MCA, a peripheral device isolation region pSTI disposed on the substrate within the extension region EXTa, a peripheral active region pACT spaced apart from the memory cell array region MCA, and gate trenches GT crossing the cell active regions cACT and the cell device isolation region cSTI.

The substrate SUB may be a semiconductor substrate. The substrate SUB may be provided as a bulk wafer, an epitaxial layer, a Silicon On Insulator (SOI) layer, a Semiconductor On Insulator (SeOI) layer, or the like. The substrate SUB may include a group IV semiconductor, a group III-V compound semiconductor, or a group II-VI compound semiconductor. For example, the substrate SUB may be a substrate including at least one of silicon, silicon carbide, germanium, or silicon-germanium. For example, the substrate SUB may be a single crystal silicon substrate including a silicon material, for example, a single crystal silicon material.

Each of the cell active regions cACT and the peripheral active region pACT may protrude from the substrate SUB in a vertical direction Z. The cell active regions cACT and the peripheral active region pACT may be formed of the same semiconductor material as the substrate SUB, for example, single crystal silicon. In plan view, each of the cell active regions cACT may have a bar shape extending in a direction oblique to the first direction X.

The cell device isolation region cSTI may be a shallow device isolation trench isolation (STI) defining the cell active regions cACT. The cell device isolation region cSTI may be formed of an insulating material including at least one of silicon oxide or silicon nitride.

The peripheral device isolation region pSTI may include an insulating layer 9, a first insulating liner 3 covering a side surface and a bottom surface of the insulating layer 9, and a second insulating liner 6 between the insulating layer 9 and the first insulating liner 3. The second insulating liner 6 may include a material different from materials of the insulating layer 9 and the first insulating liner 3. For example, the second insulating liner 6 may include nitride, and the insulating layer 9 and the first insulating liner 3 may include oxide.

End portions of the bit line structures BLS may be disposed on the peripheral device isolation region pSTI. End portions of the bit lines BL may be disposed on the peripheral device isolation region pSTI. The bit lines BL may not vertically overlap the peripheral active region pACT.

The insulating patterns 42 and the insulating spacers 30 may be disposed on the peripheral device isolation region pSTI.

Within the first and second extension regions EXTa and EXTb, lower surfaces of the insulating patterns 42 may be disposed at a lower level than lower surfaces of the bit lines BL.

Within the first and second extension regions EXTa and EXTb, upper surfaces of the insulating patterns 42 may be disposed at a higher level than upper surfaces of the bit lines BL.

Lower surfaces of the insulating patterns 42 may be disposed at a lower level than upper surfaces of the cell active regions cACT.

Within the first and second extension regions EXTa and EXTb, each of the insulating patterns 42 may include a lower region 42L disposed at a lower level than the bit lines BL, an intermediate region 42M disposed at the same level as the bit lines BL, and an upper region 42U disposed at a higher level than the bit lines BL.

The lower regions 42L of the insulating patterns 42 may contact the insulating layer 9 of the peripheral device isolation region pSTI.

Within the first and second extension regions EXTa and EXTb, each of the lower regions 42L of the insulating patterns 42 may have a greater width than each of the bit lines BL.

Within the first and second extension regions EXTa and EXTb, a maximum width of each of the intermediate regions 42L of the insulating patterns 42 may be greater than a width of each of the bit lines BL.

Within the first and second extension regions EXTa and EXTb, each of the intermediate regions 42L of the insulating patterns 42 may have a side surface that is inclined such that a width increases from top to bottom.

The semiconductor device 1 may further include gate lines GS crossing the memory cell array region MCA in the second direction Y. The gate lines GS may be disposed within the gate trenches GT.

In an example embodiment, the bit lines BL may be disposed on a level different from that of the gate lines GS. For example, the gate lines GS may be disposed at a lower level than the bit lines BL.

The gate lines GS may include dummy gate lines GSd adjacent to the first and second extension regions EXTa and EXTb.

A distance between the dummy gate line GSd, adjacent to the first extension region EXTa and end portions of the first bit lines BLa within the first extension region EXTa may be greater than a distance between the dummy gate line GSd, adjacent to the first extension region EXTa and end portions of the second bit lines BLb within the first extension region EXTa. Similarly, a distance between the dummy gate line GSd, adjacent to the second extension region EXTb and end portions of the second bit lines BLb within the second extension region EXTb may be greater than a distance between the dummy gate line GSd, adjacent to the extension region EXTb and end portions of the first bit lines BLa within the second extension region EXTb.

In example embodiments, an "end portion" may refer to a "side surface." For example, end portions of the first bit lines BLa within the first extension region EXTa may refer to side surfaces of the end portions of the first bit lines BLa. Therefore, hereinafter, even if there is no separate definition or explanation of an "end portion," it may be understood as a "side surface" or a "side surface of the end portion."

Within the first extension region EXTa, the first bit lines BLa may extend farther from the memory cell array region MCA than the second bit lines BLb, and in the second extension region EXTb, the second bit lines BLb may extend farther from the memory cell array region MCA than the first bit lines BLa.

A length of the first bit lines BLa extending from the memory cell array region MCA into the first extension region EXTa may be greater than a length of the second bit lines BLb extending from the memory cell array region MCA into the first extension region EXTa. A length of the second bit lines BLb extending from the memory cell array region MCA into the second extension region EXTb may be greater than a length of the first bit lines BLa extending from the memory cell array region MCA into the second extension region EXTb.

Within the first extension region EXTa, at least a portion of each of the first insulating patterns 42a may face the bit line contact structures 78 in the second direction Y.

Within the first extension region EXTa, a distance between end portions of the first insulating patterns 42a contacting end portions of the second bit lines BLb and the memory cell array region MCA may be greater than a distance between the bit line contact structures 78 and the memory cell array region MCA. Within the first extension region EXTa, a distance between end portions of the first insulating patterns 42a contacting end portions of the second bit lines BLb and the dummy gate line GSd may be greater than a distance between the bit line contact structures 78 and the dummy gate line GSd.

The semiconductor device 1 may further include gate capping layers GC on the gate lines GS. The gate lines GS and the gate capping layers GC may be disposed within the gate trenches GT.

Each of the gate lines GS may include a gate dielectric layer Gox and a gate electrode GE. In each of the gate lines GS, the gate dielectric layer Gox may be disposed on an inner wall of the gate trench GT, and the gate electrode GE may partially fill the gate trench GT on the gate dielectric layer Gox. The gate capping layer GC may fill a remaining portion of the gate trench GT on the gate electrode GE. The gate electrode GE and the gate capping layer GC may be sequentially stacked. An upper surface of the gate electrode GE may be disposed at a lower level than upper surfaces of the cell active regions cACT.

The gate dielectric layer Gox may be disposed between a bottom surface of the gate electrode GE and a bottom surface of the gate trench GT, between a side surface of the gate electrode GE and a sidewall of the gate trench GT, and between a side surface of the gate capping layer GC and a sidewall of the gate trench GT.

The semiconductor device 1 may further include first and second source/drain regions SD1 and SD2 within upper regions of the cell active regions cACT.

In an example embodiment, the gate electrode GE, the gate dielectric layer Gox, and the first and second source/drain regions SD1 and SD2 may constitute cell transistors TR.

The semiconductor device 1 may further include the cell active regions cACT, the cell device isolation region cSTI, the peripheral device isolation region pSTI, and a buffer insulating layer 12 on the peripheral active region pACT.

The buffer insulating layer 12 may include at least one insulating material. For example, the buffer insulating layer 12 may include at least one of silicon oxide or silicon nitride.

The bit line structures BLS may be disposed on the buffer insulating layer 12. Lower surfaces of the bit lines BL may contact the buffer insulating layer 12.

The semiconductor device 1 may further include bit line contact plugs BLp penetrating through the buffer insulating layer 12 and connecting the first source/drain regions SD1 and the bit lines BL. The bit line contact plugs BLp may include the same material as the first conductive material layers 17a of the bit lines BL.

The semiconductor device 1 may further include bit line spacers SP_U on side surfaces of the bit line structures BLS and contact spacers SP_L on side surfaces of the bit line contact plugs BLp.

Each of the bit line spacers SP_U may include an inner spacer 55, an outer spacer 59, and an intermediate spacer 57 between the inner spacer 55 and the outer spacer 59. The inner spacer 55 may contact a side surface of the bit line structure BLS. The inner spacer 55 and the outer spacer 57 may include at least one of SiN and SiCN. The intermediate spacer 57 may be an air spacer, but example embodiments thereof are not limited thereto. For example, the intermediate spacer 57 may include at least one of silicon oxide or a low dielectric material.

Each of the contact spacers SP_L may include a first spacer 53 and a second spacer 51 covering a side surface and a bottom surface of the first spacer 53. The second spacer 51 may extend from the inner spacer 55. The first spacer 53 may include at least one of SiN or SiC.

The semiconductor device 1 may further include contact plugs 75 disposed between the bit line structures BLS.

The contact plugs 75 may include a conductive material. The contact plugs 75 may include cell contact plugs 75c disposed within the memory cell array region MCA and peripheral contact plugs 75d disposed within the first and second extension regions EXTa and EXTb. The cell contact plugs 75c may be electrically connected to the second source/drain regions SD2, and the peripheral contact plugs 75d may be disposed on the peripheral device isolation region pSTI.

Within the first and second extension regions EXTa and EXTb, the peripheral contact plugs 75d may serve to mitigate or prevent deformation of the bit line structures BLS.

At least one of the peripheral contact plugs 75d disposed within the first and second extension regions EXTa and EXTb may be electrically isolated dummy contact plugs. The peripheral contact plugs 75d may contact the peripheral device isolation region pSTI.

Each of the contact plugs 75 may include a lower conductive layer 63, an upper conductive layer 73 on the lower conductive layer 63, and an intermediate conductive layer 66 between the lower conductive layer 63 and the upper conductive layer 73.

The lower conductive layer 63 may include doped polysilicon, for example, polysilicon having N-type conductivity. The intermediate conductive layer 66 may include a metal-semiconductor compound layer. The upper conductive layer 73 may include a conductive layer 72b and a barrier layer 72a covering side and bottom surfaces of the conductive layer 72b. The barrier layer 72a may include at least one of TiN, TaN, WN, TiSiN, TaSiN, or RuTiN, and the conductive layer 72b may include a metal material such as W.

The semiconductor device 1 may further include an upper spacer 69 disposed between the bit line spacer SP_U and the upper conductive layer 73 and between an upper region of the bit line structure BLS and the upper conductive layer 73. The upper spacer 69 may include an insulating material such as silicon oxide or silicon nitride.

The semiconductor device 1 may further include bit line contact structures 78. The bit line contact structures 78 may penetrate through the capping pattern 23 within the first and second extension regions EXTa and EXTb and be electrically connected to the bit lines BL. For example, among the bit line contact structures 78, the bit line contact structures 78 disposed within the first extension region EXTa may penetrate through the capping pattern 23 and electrically connected to the first bit lines BLa, and among the bit line contact structures 78, the bit line contact structures 78 disposed within the second extension region EXTb may penetrate through the capping pattern 23 and electrically connect to the second bit lines BLb.

Each of the bit line contact structures 78 may include a first conductive layer 77b and a second conductive layer 77a covering side and bottom surfaces of the first conductive layer 77b. The second conductive layer 77a may include at least one of TiN, TaN, WN, TiSiN, TaSiN, or RuTiN, and the first conductive layer 72b may include a metal material such as W.

The semiconductor device 1 may further include an interlayer insulating layer 36 disposed within the first and second extension regions EXTa and EXTb, not covered by the bit line structures BLS, the insulating patterns 42, and the insulating spacers 30. The interlayer insulating layer 36 may include at least one of silicon oxide or a low dielectric material.

The interlayer insulating layer 36 may be disposed on the peripheral device isolation region pSTI and the peripheral active region pACT. An upper surface of the interlayer insulating layer 36 may be coplanar with an upper surface of the second insulating material layer 33a of the capping patterns 23.

The insulating spacers 30 may cover end portions of the bit lines BL and cover side surfaces of the second insulating material layer 33a of the capping patterns 23.

The insulating spacers 30 may be disposed between the interlayer insulating layer 36 and the bit lines BL and between the interlayer insulating layer 36 and the first insulating material layer 24a.

Upper ends of the insulating spacers 30 may be disposed at a higher level than upper surfaces of the bit lines BL, and lower ends of the insulating spacers 30 may be disposed at a lower level than lower surfaces of the bit lines BL. The lower ends of the insulating spacers 30 may be disposed at a lower level than upper surfaces of the cell and peripheral active regions cACT and pACT, and may contact the peripheral device isolation region pSTI.

The insulating patterns 42 may be disposed between the bit line structures BLS and the interlayer insulating layer 36.

The semiconductor device 1 may further include an insulating liner 33e extending from the second insulating material layers 33a of the capping patterns 23 provided between the insulating spacers 30 and the interlayer insulating layer 36, and covering a lower surface of the interlayer insulating layer 36.

The semiconductor device 1 may further include an upper insulating layer 39e disposed on the interlayer insulating layer 36, and disposed on the same level as the third insulating material layers 39a of the capping patterns 23.

The semiconductor device 1 may further include conductive patterns 80c and 80b. Each of the conductive patterns 80c and 80b may include at least one conductive material. Each of the conductive patterns 80c and 80b may include at least one of Cu, Ti, Ta, Ru, W, Mo, Pt, Ni, Co, TiN, TaN, WN, NbN, TiAl, TiAlN, TiSi, TiSiN, TaSi, TaSiN, RuTiN, or NiSi.

The conductive patterns 80c and 80b may include first conductive patterns 80c within the memory cell array region MCA and second conductive patterns 80b within the first and second extension regions EXTa and EXTb.

The first conductive patterns 80c may be electrically connected to the cell contact plugs 75c on the cell contact plugs 75c. The first conductive patterns 80c may be electrically connected to the second source/drain regions SD2 of the cell transistors TR by the cell contact plugs 75c.

The second conductive patterns 80b may be electrically connected to the bit line contact structures 78 within the first and second extension regions EXTa and EXTb. For example, among the second conductive patterns 80b, the second conductive patterns 80b disposed within the first extension region EXTa may be electrically connected to the first bit lines BLa by the bit line contact structures 78, and among the second conductive patterns, the second conductive patterns 80b disposed within the second extension region EXTb may be electrically connected to the second bit lines BLb by the bit line contact structures 78.

The second conductive patterns 80b may be interconnection lines for connecting the bit lines BL to a peripheral circuit such as a sense amplifier.

The first conductive patterns 80c may be referred to as 'conductive pads', and the second conductive patterns 80b may be referred to as 'bit line interconnection lines' or 'interconnection lines'.

The semiconductor device 1 may further include an insulating isolation pattern 83, an etch stop layer 87, and a data storage structure DS.

The insulating isolation pattern 83 may be disposed on side surfaces of the conductive patterns 80c and 80b, and may extend downwardly. The insulating isolation pattern 83 may be disposed at a higher level than the bit lines BL.

The etch stop layer 87 may be disposed on the insulating isolation pattern 83 and the conductive patterns 80c and 80b, and may be formed of an insulating material.

The data storage structure DS may be disposed within the memory cell array region MCA.

In one example, the data storage structure DS may be a capacitor for storing data in a DRAM. For example, the data storage structure DS may be a DRAM capacitor including first electrodes 90 penetrating through the etch stop layer 87 and electrically connected to the first conductive patterns 80c, a dielectric layer 92 covering the first electrodes 90 and the etch stop layer 87, and a second electrode 94 on the dielectric layer 92. The dielectric layer 92 may include a high dielectric, silicon oxide, silicon nitride, silicon oxynitride, or a combination thereof. The high dielectric may be a dielectric having a higher dielectric constant than that of silicon oxide.

In another example, the data storage structure DS may be a structure for storing a DRAM and other memory data. For example, in the data storage structure DS, the dielectric layer 92 may include a ferroelectric layer for recording data using a polarization state.

According to the above-described embodiment, even if the size of the bit line structures BLS is reduced, at least one of the insulating patterns 42, the insulating spacers 30, and the peripheral contact plugs 75d may mitigate or prevent defects such as deformation of the bit line structures BLS. Accordingly, a degree of integration of the semiconductor device 1 may be increased, and reliability of the semiconductor device 1 may be improved.

Hereinafter, various modified examples of the above-described example embodiment for increasing the degree of integration and improving the reliability of the semiconductor device 1 will be described. Various modified examples of elements of the above-described example embodiment described below will be described focusing on modified elements, replaced elements, or added elements. In addition, elements that can be modified or replaced described below are described with reference to the following drawings, but the elements that can be modified or replaced may be combined with each other or with the elements described above to form semiconductor devices according to some example embodiments of the present inventive concepts.

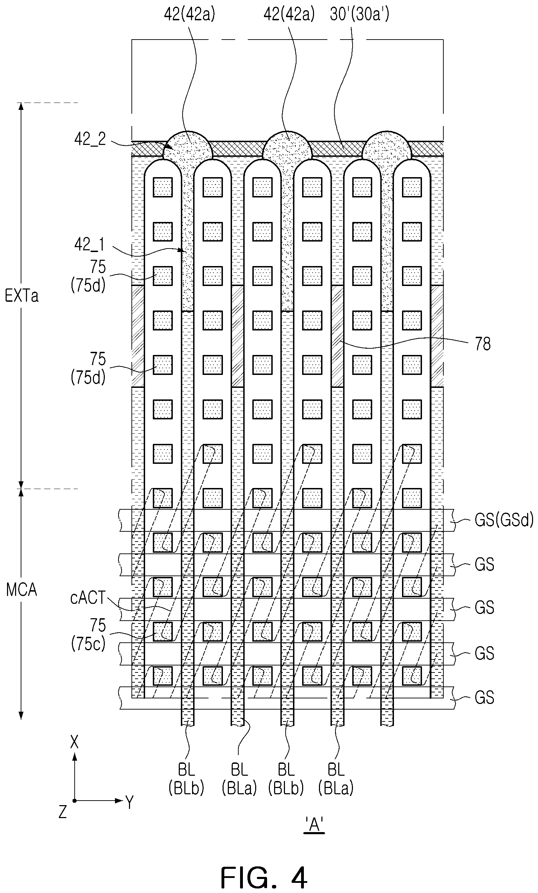

A modified example of a semiconductor device according to an example embodiment of the present inventive concepts will be described with reference to FIG. 4. FIG. 4 is a plan view for illustrating a modified example of FIG. 2.

In a modified example, referring to FIG. 4, within the first extension region EXTa, the first bit lines BLa may extend to contact the second portions 42_2 of the first insulating patterns 42a. Similarly, within the second extension region EXTb, the second bit lines BLb may extend to contact the second portions 42_2 of the second insulating patterns 42b.

Within the first extension region EXTa, end portions of the first bit lines BLa may have an increased width. For example, within the first extension region EXTa, each of the first bit lines BLa may have a first width between the first portions 42_1 of the first insulating patterns 42a, and may have a second width greater than the first width between the second portions 42_2 of the first insulating patterns 42a.

The insulating spacers 30 described above may be modified into insulating spacers 30' that contact the insulating patterns 42. For example, the first insulating spacers (30a in FIG. 2) contacting end portions of the first bit lines BLa may be modified into first insulating spacers 30a' contacting the second portions 42_2 of the first insulating patterns 42a.

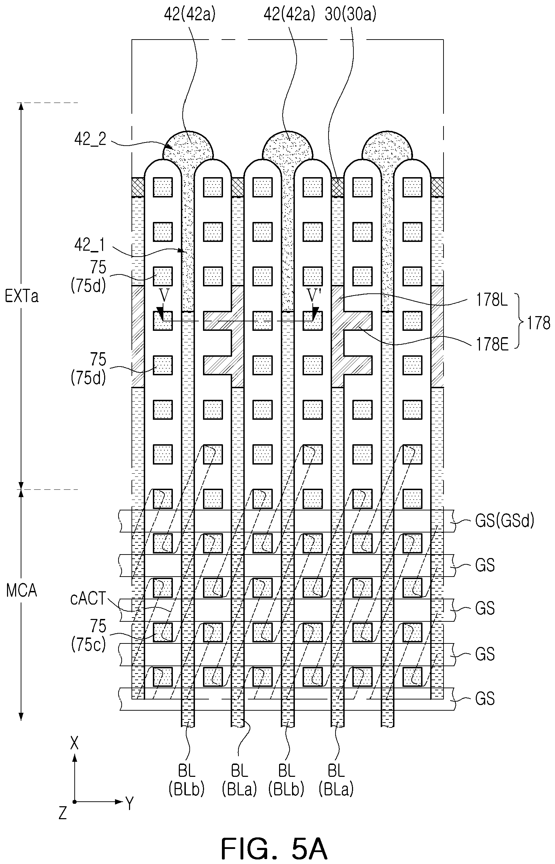

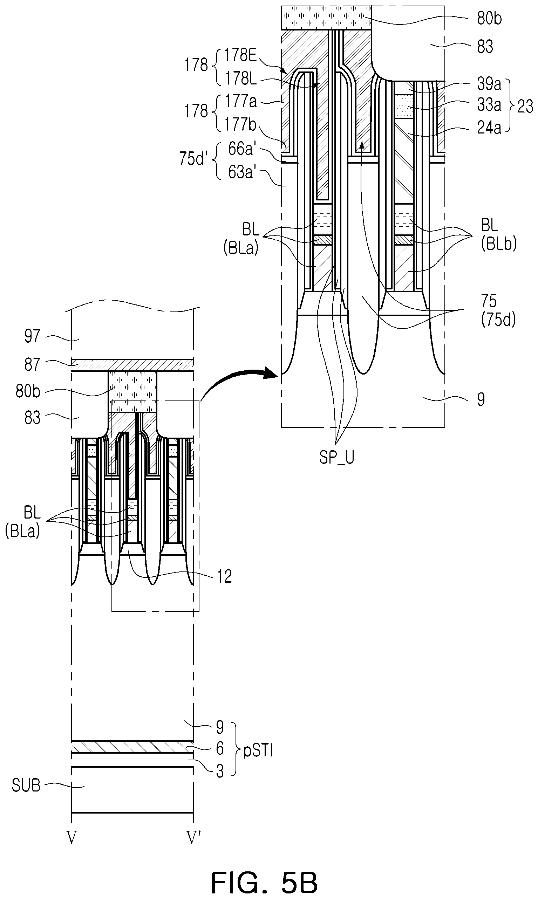

A modified example of a semiconductor device according to an example embodiment of the present inventive concepts will be described with reference to FIGS. 5A and 5B. FIG. 5A is a plan view for explaining a modified example of FIG. 2, and FIG. 5B is a cross-sectional view taken along line V-V' of FIG. 5A and illustrating a modified example of FIG. 3E.

In a modified example, referring to FIGS. 5A and 5B, the bit line contact structures (78 in FIGS. 2 and 3E) described above may be replaced with bit line contact structures 178 as illustrated in FIGS. 5A and 5B.

Each of the bit line contact structures 178 may include a contact portion 178L contacting the bit lines BL and at least one extension portion 178E extending from the contact portion 178L. In plan view, the at least one extension portion 178E may extend from the contact portion 178L in the second direction Y.

To reduce contact resistance between the bit lines BL and the bit line contact structures 178 by increasing a contact area between the bit lines BL and the bit line contact structures 178, each of the contact portions 178L may have a bar shape extending in the first direction X.

The contact portions 178L may have substantially the same width as the bit lines BL, but example embodiments are not limited thereto. For stable contact between the contact portions 178L and the bit lines BL, the contact portions 178L may be modified to have a width greater than that of the bit lines BL.

Upper surfaces of the at least one extension portion 178E of the bit line contact structures 178 may contact the second conductive patterns 80b.

Each of the bit line contact structures 178 may include a first conductive layer 177a and a second conductive layer 177b covering side and bottom surfaces of the first conductive layer 177a.

A portion of the peripheral contact plugs (75d in FIGS. 2, 3D, and 3E) described above, may be modified into first peripheral contact plugs 75d' connected to the at least one extension portion 178E of each of the bit line contact structures 178. Among the peripheral contact plugs 75, peripheral contact plugs 75 not connected to the bit line contact structures 178 may be referred to as second peripheral contact plugs 75d.

Upper surfaces of the first peripheral contact plugs 75d' may be disposed on a level lower than upper surfaces of the second peripheral contact plugs 75d. Each of the first peripheral contact plugs 75d' may include a lower conductive layer 63a' and an intermediate conductive layer 66a' respectively corresponding to the lower conductive layer 63a and the intermediate conductive layer 66a, described above.

Lower surfaces of the contact portions 178L may be disposed on a level lower than upper surfaces of the first peripheral contact plugs 75d'.

In each of the bit line contact structures 178, the at least one extension portion 178E may extend from an upper region of the contact portion 178L to vertically overlap the bit line spacer SP_U and the first peripheral contact plugs 75d'.

In each of the bit line contact structures 178, the at least one extension portion 178E may be a plurality of extension portions 178E spaced apart from each other in the first direction X.

Because the at least one extension portion 178E may increase a contact area between the bit line contact structures 178 and the second conductive patterns 80b, contact resistance between the bit line contact structures 178 and the second conductive patterns 80b may be reduced. Accordingly, the performance of the semiconductor device can be improved.

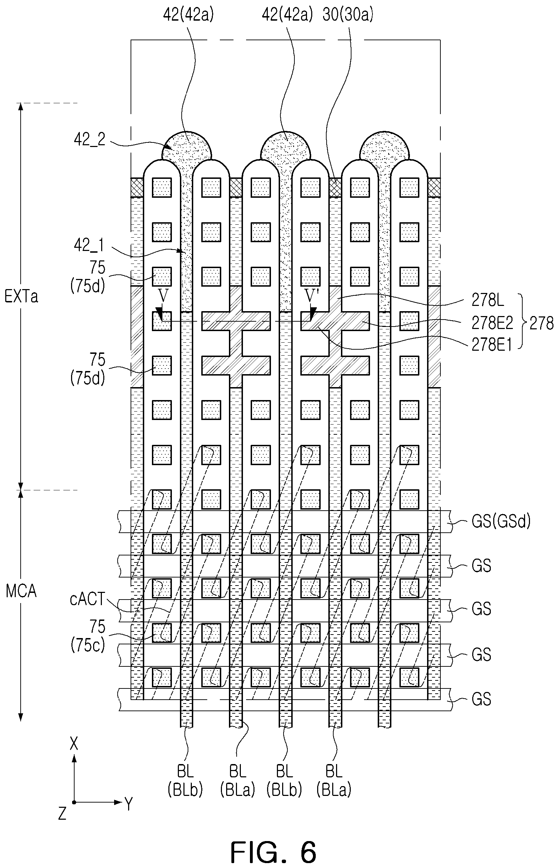

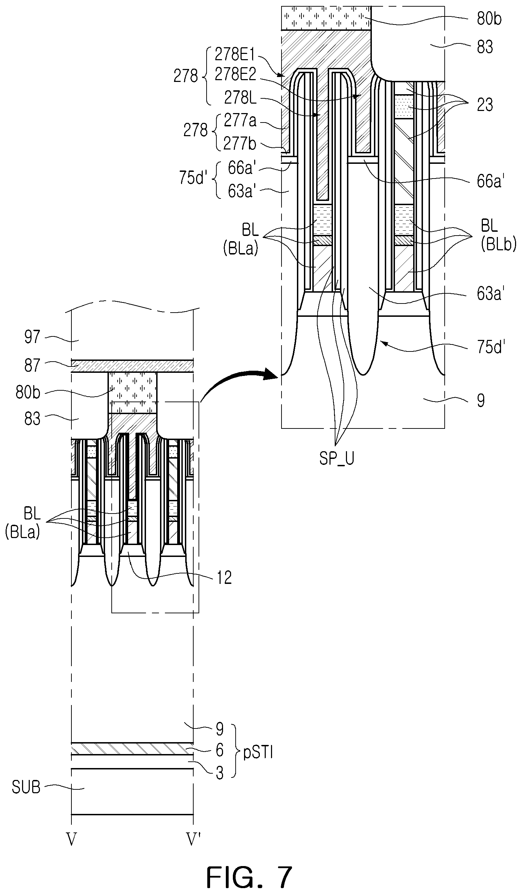

Next, a modified example of a semiconductor device according to an example embodiment of the present inventive concepts will be described with reference to FIGS. 6 and 7. FIG. 6 is a plan view for illustrating a modified example of FIG. 2, and FIG. 7 is a cross-sectional view taken along the line V-V' of FIG. 6 and illustrating a modified example of FIG. 3E.

In a modified example, referring to FIGS. 6 and 7, the bit line contact structures (78 in FIGS. 2 and 3E) described above may be replaced with bit line contact structures 278 as illustrated in FIGS. 6 and 7.

Each of the bit line contact structures 278 may include a contact portion 278L contacting the bit lines BL, at least one first extension portion 278E1 extending from the contact portion 278L to a first side, and at least one second extension portion 278E2 extending from the contact portion 278L to a second side.

The at least one first extension portion 278E1 and the at least one second extension portion 278E2 may be disposed on both sides of the contact portion 278L.

Each of the bit line contact structures 278 may include a first conductive layer 277a and a second conductive layer 277b covering side and bottom surfaces of the first conductive layer 277a.

A portion of the peripheral contact plugs (75d in FIGS. 2, 3D, and 3E) described above may be modified to form first peripheral contact plugs 75d' connected to the at least one first extension portion 278E1 and the second at least one extension portion 278E2 of each of the bit line contact structures 278.

Among the peripheral contact plugs 75d, peripheral contact plugs 75d not connected to the bit line contact structures 278 may be referred to as second peripheral contact plugs 75d. Upper surfaces of the first peripheral contact plugs 75d' may be disposed on a level lower than upper surfaces of the second peripheral contact plugs 75d. Each of the first peripheral contact plugs 75d' may include a lower conductive layer 63a' and an intermediate conductive layer 66a' respectively corresponding to the lower conductive layer 63a and the middle conductive layer 66a, described above.

In each of the bit line contact structures 278, the at least one first extension portion 278E1 and the at least one second extension portion 278E2 may extend from an upper region of the contact portion 278L to vertically overlap the bit line spacer SP_U and the first peripheral contact plugs 75d'.

In each of the bit line contact structures 278, the at least one first extension portion 278E1 may be a plurality of first extension portions 278E1 spaced apart from each other in the first direction X, and the at least one second extension portion 278E2 may be a plurality of second extension portions 278E2 spaced apart from each other in the first direction X.

Because the at least one first extension portion 278E1 and the at least one second extension portion 278E2 may increase a contact area between the bit line contact structures 278 and the second conductive patterns 80b, contact resistance between the bit line contact structures 278 and the second conductive patterns 80b may be reduced. Accordingly, the performance of the semiconductor device can be improved.

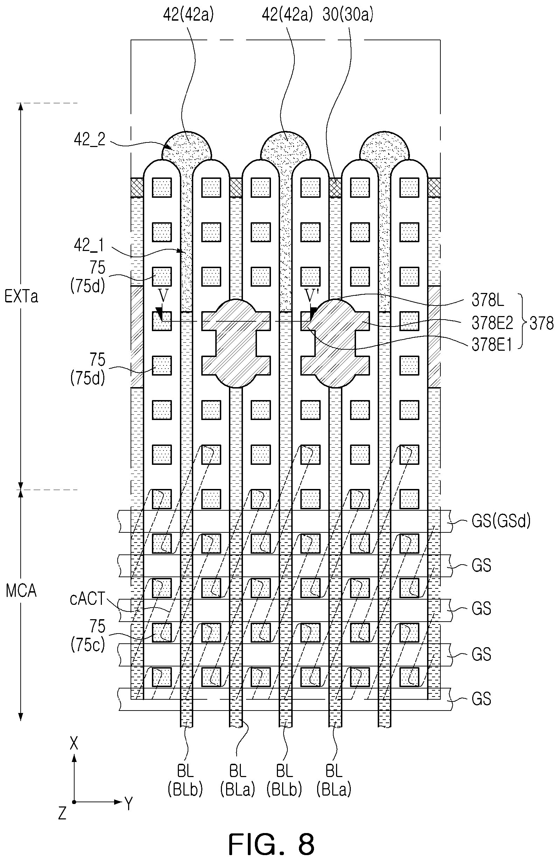

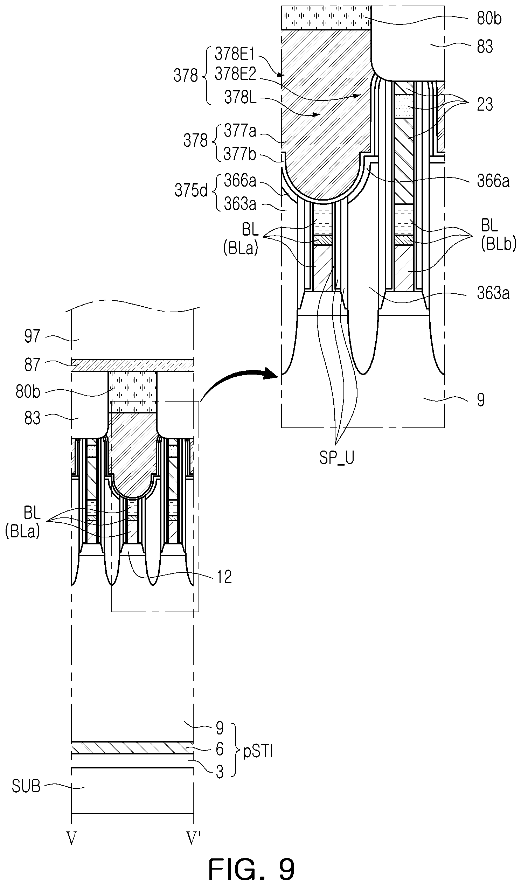

Next, a modified example of a semiconductor device according to an example embodiment of the present inventive concepts will be described with reference to FIGS. 8 and 9. FIG. 8 is a plan view for illustrating a modified example of FIG. 2, and FIG. 9 is a cross-sectional view taken along the line V-V' of FIG. 8 and illustrating a modified example of FIG. 3E.

In a modified example, referring to FIGS. 8 and 9, the bit line contact structures (78 in FIGS. 2 and 3E) described above may be replaced with bit line contact structures 378 as illustrated in FIGS. 8 and 9.

Each of the bit line contact structures 378 may include a contact portion 378L contacting the bit lines BL, at least one first extension portion 378E1 extending from the contact portion 378L to a first side. and at least one second extension portion 378E2 extending from the contact portion 378L to a second side. The at least one first extension portion 378E1 and the at least one second extension portion 378E2 may be disposed on both sides of the contact portion 378L. Each of the bit line contact structures 378 may include a first conductive layer 377a and a second conductive layer 377b covering side and bottom surfaces of the first conductive layer 377a.

A portion of the previously described peripheral contact plugs (75d in FIGS. 2, 3D, and 3E) may be modified to be first peripheral contact plugs 375d connected to the at least one first extension portion 378E1 and the at least one second extension portion 378E2 of each of the bit line contact structures 378.

Among the peripheral contact plugs 375d, peripheral contact plugs 375d not connected to the bit line contact structures 378 may be referred to as second peripheral contact plugs 75d. Each of the first peripheral contact plugs 375d may include a lower conductive layer 363a and an intermediate conductive layer 366a respectively corresponding to the lower conductive layer 63a and the intermediate conductive layer 66a described above.

Each of the contact portions 378L may have a line shape extending in the first direction X. The contact portions 378L may have a greater width than the bit lines BL. The contact portions 378L may contact the bit lines BL and contact the first peripheral contact plugs 375d. For example, when viewed based on one bit line BL and one contact portion 378L contacting each other, the contact portion 378L may contact the bit line BL and contact the first peripheral contact plugs 375d disposed on both sides of the bit line BL. Accordingly, because the contact portion 378L may stably contact the bit line BL, reliability of the semiconductor device may be improved.

In each of the bit line contact structures 378, the at least one first extension portion 378E1 and the at least one second extension portion 378E2 may extend from an upper region of the contact portion 378L to vertically overlap the bit line spacer SP_U and the first peripheral contact plugs 75d'.

In each of the bit line contact structures 378, the at least one first extension part 378E1 may be a plurality of first extension portions 378E1 spaced apart from each other in the first direction X, and the at least one second extension portion 378E2 may be a plurality of second extension portions 378E2 spaced apart from each other in the first direction X.

Because the at least one first extension portion 378E1 and the at least one second extension portion 378E2 may increase a contact area between the bit line contact structures 378 and the second conductive patterns 80b, contact resistance between the bit line contact structures 378 and the second conductive patterns 80b may be reduced. Accordingly, the performance of the semiconductor device can be improved.

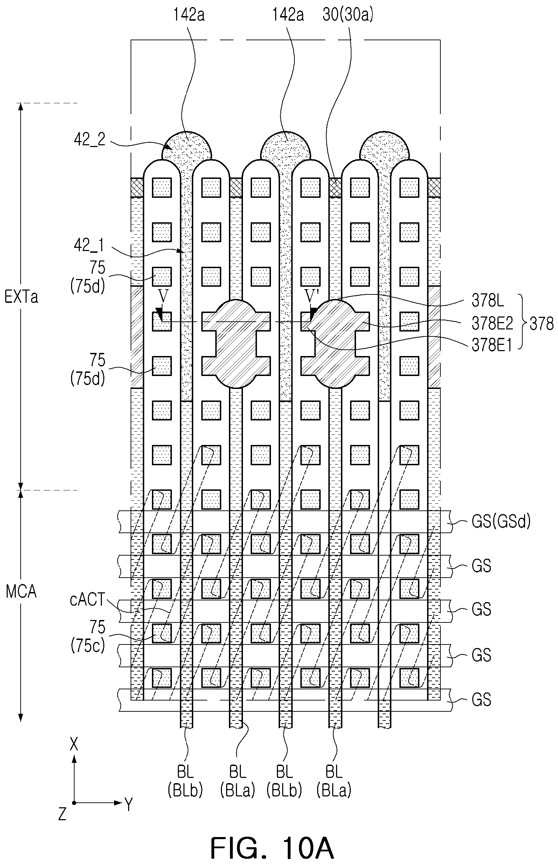

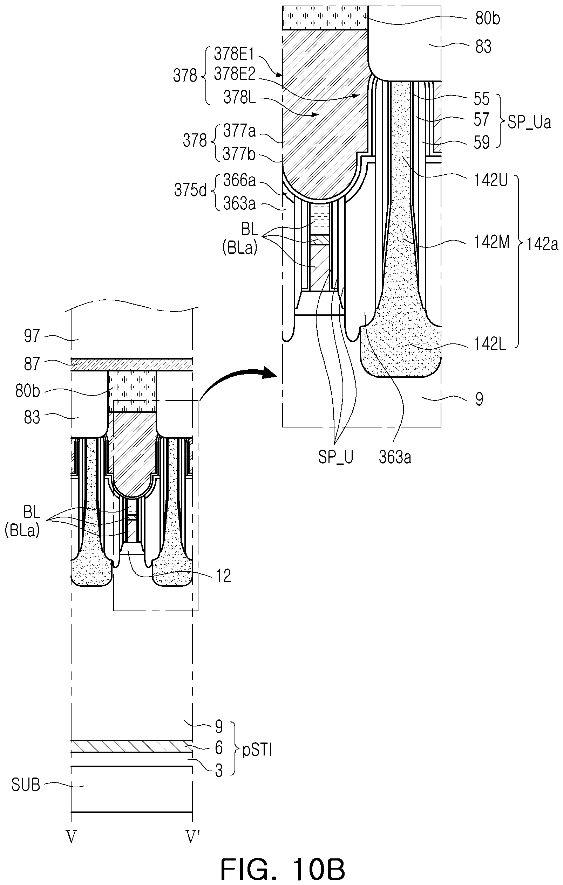

In the example embodiments described above with reference to FIGS. 1 to 9, within the first extension region EXTa, at least a portion of each of the bit line contact plugs (78 in FIGS. 1 to 3E, 178 in FIGS. 5A and 5B, 278 in FIGS. 6 and 7, and 378 in FIGS. 8 and 9) may face the adjacent second bit lines BLb in the second direction Y, but example embodiments are not limited thereto. For example, within the first extension region EXTa, the bit line contact plugs (78 in FIGS. 1 to 3E, 178 in FIGS. 5A and 5B, 278 in FIGS. 6 and 7, and 378 in FIGS. 8 and 9) may not face the second bit lines BLb in the second direction Y. For example, within the first extension region EXTa, the first insulating patterns (42a in FIGS. 1 to 9) connected to end portions of the second bit lines BLb may be modified so that the second bit lines BLb do not face the bit line contact plugs (78 in FIGS. 1 to 3E, 178 in FIGS. 5A and 5B, 278 in FIGS. 6 and 7, and 378 in FIGS. 8 and 9). Modified examples of the first insulating patterns (42a in FIGS. 1 to 9) will be described with reference to FIGS. 10A and 10B.

Next, a modified example of a semiconductor device according to an example embodiment of the present inventive concepts will be described with reference to FIGS. 10A and 10B. FIG. 10A is a plan view illustrating a modified example of the first insulating pattern 42a in FIG. 8) to explain a modified example of the first insulating patterns 42a in FIGS. 1 to 9), and FIG. 10B is a cross-sectional view taken along line V-V' of FIG. 10A to illustrate a modified example in FIG. 9.

In a modified example, referring to FIGS. 10A and 10B, the first insulating patterns (42a in FIGS. 1 to 9) connected to end portions of the second bit lines BLb described above may be modified to be first insulating patterns 142a as illustrated in FIGS. 10A and 10B.

Within the first extension region EXTa, the first insulating patterns 142a may be connected to end portions of the second bit lines BLb, and the first insulating patterns 142a may face the bit line contact plugs (78 in FIGS. 1 to 3E, 178 in FIGS. 5A and 5B, 278 in FIGS. 6 and 7, and 378 in FIGS. 8 and 9) in the second direction Y.

Within the first extension region EXTa, a distance between end portions of the first insulating patterns 142a contacting end portions of the second bit lines BLb and the memory cell array region MCA may be smaller than a distance between the bit line contact plugs (78 in FIGS. 1 to 3E, 178 in FIGS. 5A and 5B, 278 in FIGS. 6 and 7, and 378 in FIGS. 8 and 9) and the memory cell array region MCA.

Within the first extension region EXTa, a distance between end portions of the first insulating patterns 142a contacting end portions of the second bit lines BLb and the memory cell array region MCA may be smaller than a distance between the bit line contact plugs (78 in FIGS. 1 to 3E, 178 in FIGS. 5A and 5B, 278 in FIGS. 6 and 7, and 378 in FIGS. 8 and 9) and the dummy gate line GSd.

The second insulating patterns (42b in FIG. 1) within the second extension region EXTb may be modified like the first insulating patterns 142a.

Each of the first insulating patterns 142a may include a lower region 142L, an intermediate region 142M, and an upper region 142U, corresponding to the lower region 42L in FIG. 3D, the intermediate region 42M in FIG. 3D, and the upper region 42U in FIG. 3D, respectively.

Because the first insulating patterns 142a can reduce an area where the first and second bit lines BLa and BLb face each other, parasitic capacitance between the first and second bit lines BLa and BLb may be reduced. Accordingly, the performance of the semiconductor device may be improved.

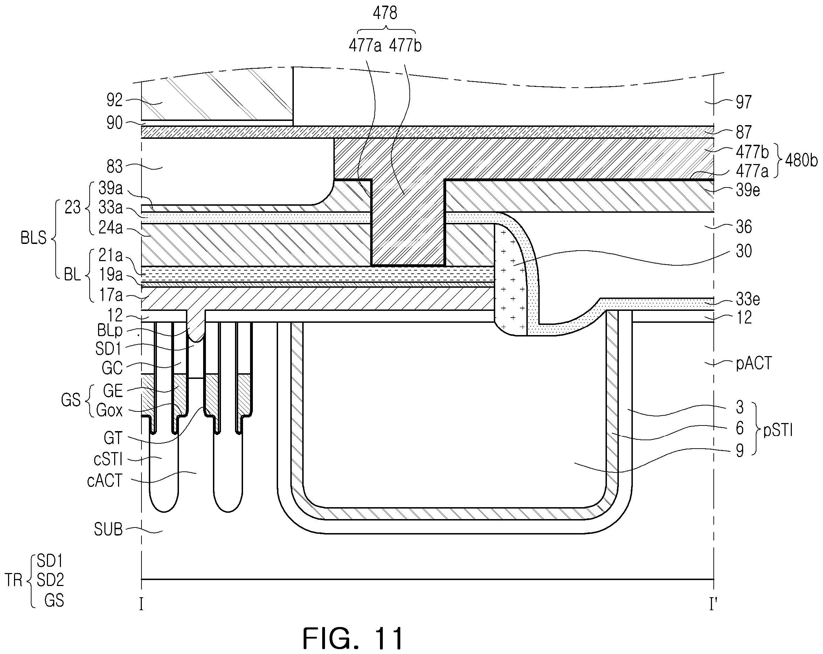

The bit line contact plugs (78 in FIGS. 1 to 3E, 178 in FIGS. 5A and 5B, 278 in FIGS. 6 and 7, and 378 in FIGS. 8 and 9) described above may form an interface and contact the second conductive patterns (80b in FIGS. 1 to 10B), but example embodiments are not limited thereto. For example, the bit line contact plugs (78 in FIGS. 1 to 3E, 178 in FIGS. 5A and 5B, 278 in FIGS. 6 and 7, and 378 in FIGS. 8 and 9) may be integrally formed with the second conductive patterns (80b of FIGS. 1 to 10B). As described above, a modified example of the bit line contact plugs (78 in FIGS. 1 to 3E, 178 in FIGS. 5A and 5B, 278 in FIGS. 6 and 7, and 378 in FIGS. 8 and 9) and the second conductive patterns (80b in FIGS. 1 to 10B) will be described with reference to FIG. 11. FIG. 11 is a cross-sectional view illustrating a modified example in which the bit line contact structure 78 and the second conductive pattern 80b in FIG. 3A are integrally formed, in order to illustrate a modified example of the bit line contact plugs (78 in FIGS. 1 to 3E, 178 in FIGS. 5A and 5B, 278 in FIGS. 6 and 7, and 378 in FIGS. 8 and 9) and the second conductive patterns (80b in FIGS. 1 to 10B).

Referring to FIG. 11, the bit line contact plugs (78 in FIGS. 1 to 3E, 178 in FIGS. 5A and 5B, 278 in FIGS. 6 and 7, and 378 in FIGS. 8 and 9) and the second conductive patterns (80b in FIGS. 1 to 10B) may be modified to be integrally formed. For example, the bit line contact plugs (78 in FIGS. 1 to 3E, 178 in FIGS. 5A and 5B, 278 in FIGS. 6 and 7, and 378 in FIGS. 8 and 9) and the second conductive patterns (80b in FIGS. 1 to 10B) may be modified to have bit line contact plugs 478 and second conductive patterns 480b, which are integrally formed.

Among the bit line contact plugs 478 and the second conductive patterns 480b, considering one bit line contact plug 478 and one second conductive pattern 480b connected to each other as a reference, the bit line contact plug 478 and the second conductive pattern 480b may be integrally formed. The bit line contact plug 478 and the second conductive pattern 480b may include a first conductive layer 477b and a second conductive layer 477a covering a lower portion of the first conductive layer 477b.

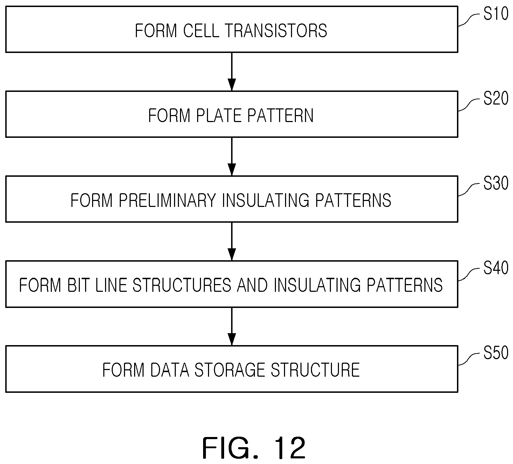

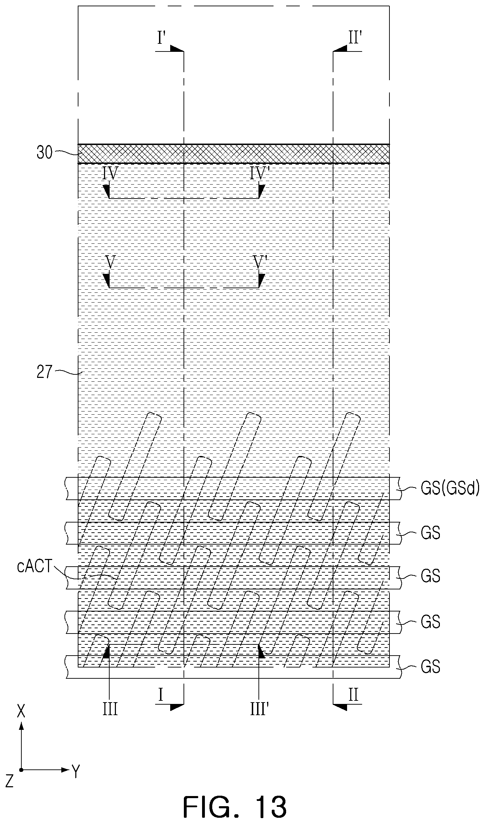

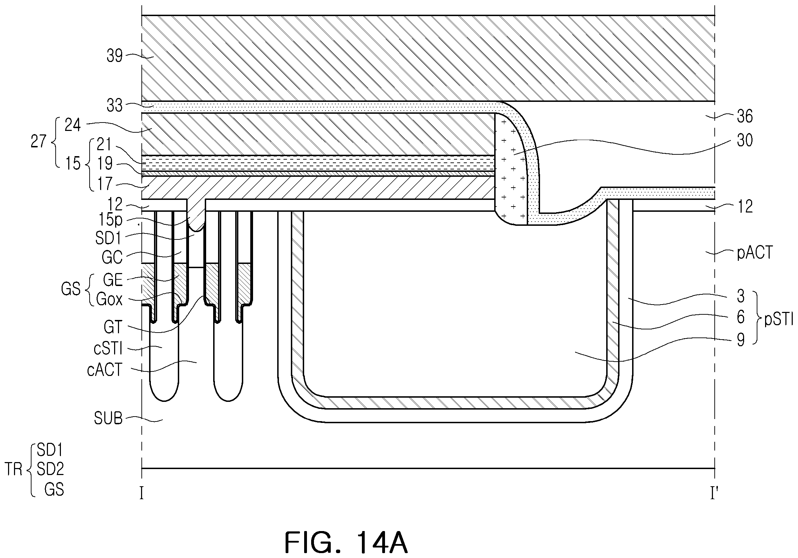

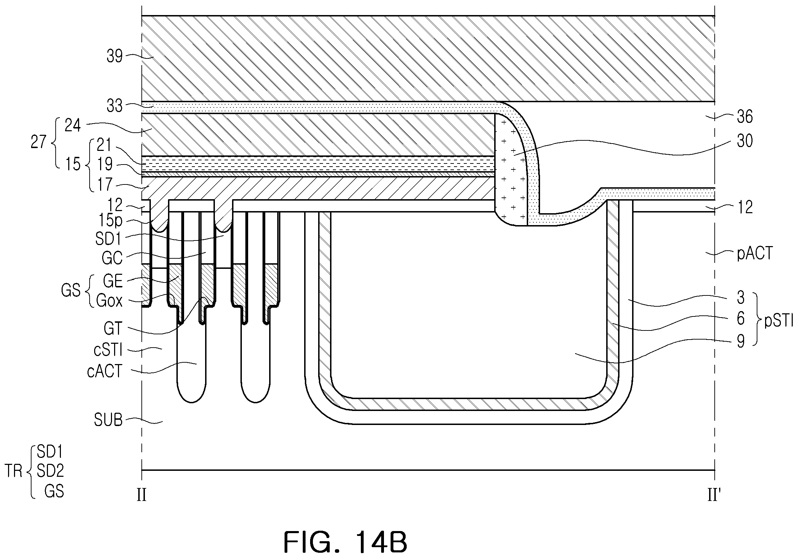

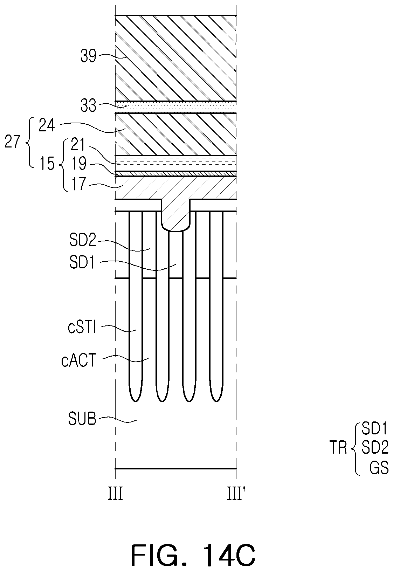

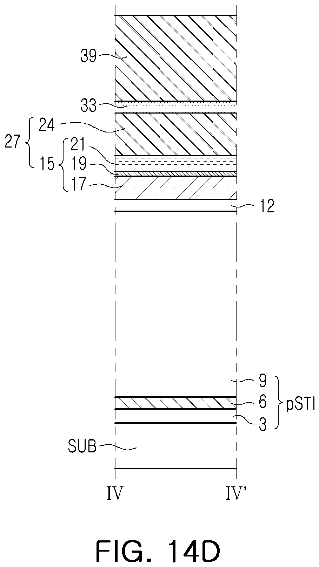

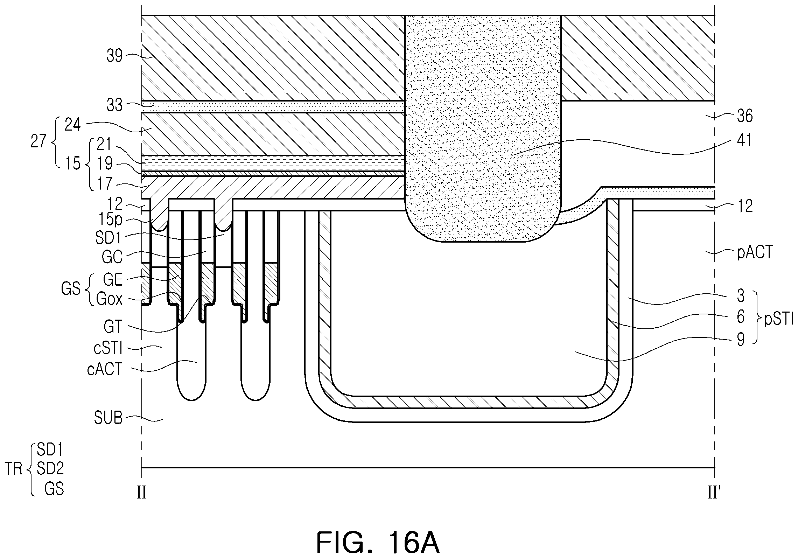

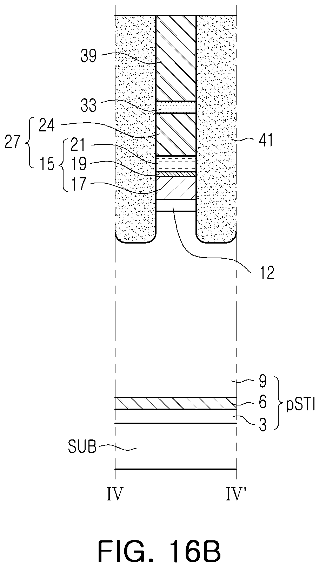

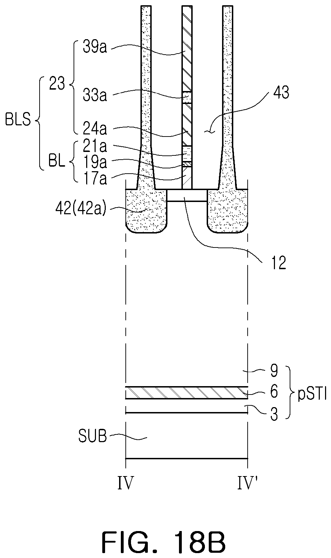

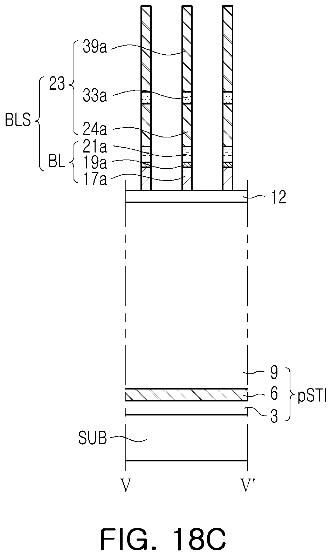

Next, with reference to FIGS. 1 and 12 to 18C, an illustrative example of a method for manufacturing a semiconductor device according to an example embodiment of the present inventive concepts will be described. In FIGS. 12 to 18C, FIG. 12 is a process flow diagram for illustrating a method for manufacturing a semiconductor device according to an example embodiment of the present inventive concepts, FIGS. 13, 15, and 17 are plan views corresponding to a region indicated by 'A' in FIG. 1 for illustrating an a method for manufacturing a semiconductor device according to an example embodiment of the present inventive concepts, FIG. 14A is a cross-sectional view taken along line I-I' of FIG. 2, FIGS. 14B and 16A are cross-sectional views illustrating a region taken along line II-II' of FIG. 2, FIGS. 14C and 18A are cross-sectional views illustrating a region taken along line III-III' of FIG. 2, FIGS. 14D, 16B, and 18B are cross-sectional views illustrating a region taken along the line IV-IV' of FIG. 2, and FIG. 18C is cross-sectional view illustrating a region taken along line V-V' of FIG. 2.

Referring to FIGS. 1, 12, 13, and 14A to 14D, a cell transistor TR may be formed (S10). Forming the cell transistor TR may include forming device isolation regions cSTI and pSTI defining cell active regions cACT and a peripheral active region pACT on a substrate SUB, forming gate trenches GT crossing a cell device isolation region cST and the cell active regions cACT among the cSTI and pSTI, and forming gate structures GS and GC in the gate trenches GT.

Forming the cell transistor TR may further include forming first and second source/drain regions SD1 and SD2 in the cell active regions cACT.

Each of the gate structures GS and GC may include a gate line GS and a gate capping layer GC on the gate line GS. Each of the gate lines GS may include a gate dielectric layer Gox and a gate electrode GE. In each of the gate lines GS, the gate dielectric layer Gox may be disposed on an inner wall of the gate trench GT, and the gate electrode GE may partially fill the gate trench GT on the gate dielectric layer Gox. The gate capping layer GC may fill a remaining portion of the gate trench GT on the gate electrode GE.

The cell transistor TR may include the gate electrode GE, the gate dielectric layer Gox, and the first and second source/drain regions SD1 and SD2.

The device isolation regions cSTI and pSTI may include a cell device isolation region cSTI within the memory cell array region MCA and a peripheral device isolation region pSTI in the extension regions EXTa and EXTb. The peripheral device isolation region pSTI may include an insulating layer 9, a first insulating liner 3 covering a side surface and a bottom surface of the insulating layer 9, and a second insulating liner 6 between the insulating layer 9 and the first insulating liner 3.

A buffer insulating layer 12 covering the cell active regions cACT, the device isolation regions cSTI and pSTI, and covering the gate structures GS and GC, and having openings exposing the first source/drain regions SD1, may be formed.

A plate pattern 27 may be formed (S20). The plate pattern 27 may be formed on the buffer insulating layer 12, and may contact the first source/drain regions SD1 exposed by the buffer insulating layer 12.

The plate pattern 27 may include at least one conductive layer 15 and a lower insulating layer 24 on the at least one conductive layer 15.

The at least one conductive layer 15 may include a first conductive material layer 17, a second conductive material layer 19, and a third conductive material layer 21. The at least one conductive layer 15 may include a plug portion 15p penetrating through the buffer insulating layer 12 and contacting the first source/drain regions SD1.

The lower insulating layer 24 may include an insulating material such as silicon nitride.

An end portion of the plate pattern 27 may be located on the peripheral device isolation region pSTI.

An insulating spacer 30 may be formed on a side surface of the plate pattern 27. The insulating spacer 30 may include at least one insulating material. For example, the insulating spacer 30 may include at least one of silicon oxide, low dielectric material, or silicon nitride.

A conformal insulating liner 33 may be formed on a substrate having the plate pattern 27 and the insulating spacer 30. The insulating liner 33 may include silicon nitride.

An insulating layer may be formed on the substrate having the insulating liner 33, and the insulating layer may be planarized until the insulating liner 33 on the plate pattern 27 is exposed to form an interlayer insulating layer 36. The interlayer insulating layer 36 may include at least one of silicon oxide or a low dielectric material.

An insulating layer 39 may be formed on the insulating liner 33 and the interlayer insulating layer 36. The insulating layer 39 may include silicon nitride.

Referring to FIGS. 1, 12, 15, 16A and 16B, preliminary insulating patterns 41 may be formed (S30). Each of the preliminary insulating patterns 41 may have a bar shape extending in a first direction (X).

The preliminary insulating patterns 41 may pass through the insulating layer 39, the insulating liner 33, the insulating spacer 30, and the plate pattern 27 and contact the peripheral device isolation region pSTI. The preliminary insulating patterns 41 may include silicon nitride.

Referring to FIGS. 1, 12, 17, and 18A to 18C, insulating patterns 42 and bit line structures BLS may be formed (S40).

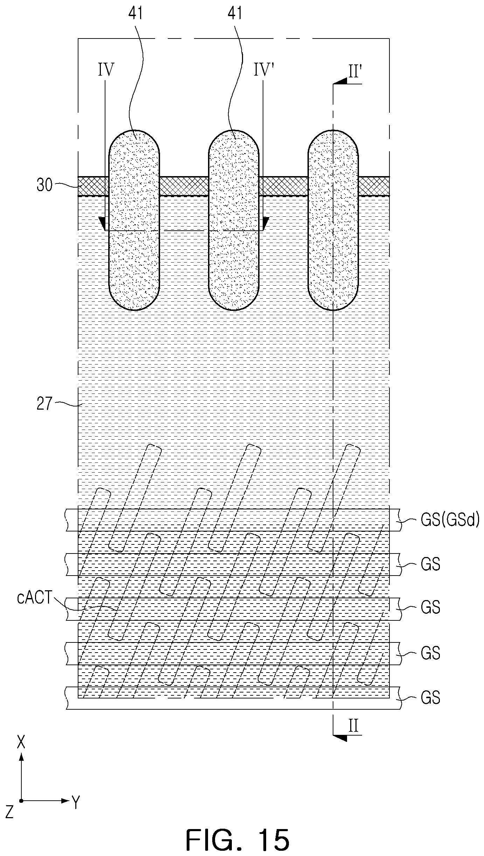

Forming the insulating patterns 42 and the bit line structures BLS may include forming openings 43 and structures spaced apart from each other by the openings 43 in a second direction Y, by patterning the insulating layer (39 of FIGS. 15 to 16B), the preliminary insulating patterns (41 of FIGS. 15 to 16B), and the plate pattern (27 of FIGS. 15 to 16B).

Each of the openings 43 may have a line shape extending in a first direction Y.

The preliminary insulating patterns (41 of FIGS. 15 to 16B) may be patterned to form the insulating patterns 42 of any one of the example embodiments of FIGS. 1 to 11 described above.

The insulating layer (39 in FIGS. 15 to 16B) and the plate pattern (27 in FIGS. 15 to 16B) may be patterned to form the bit line structures BLS of any one of the example embodiments of FIGS. 1 to 11 described above. Accordingly, as in any one of the example embodiments of FIGS. 1 to 11 described above, each of the bit line structures BLS may include a bit line BL and a capping pattern 23, sequentially stacked.

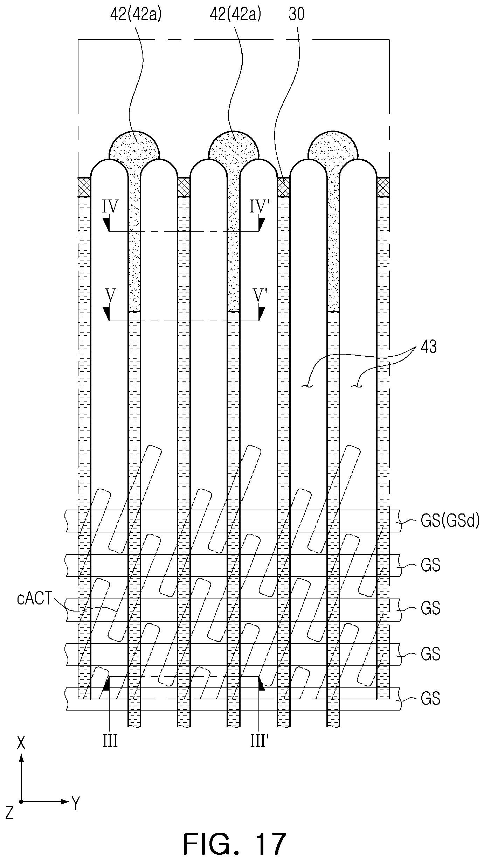

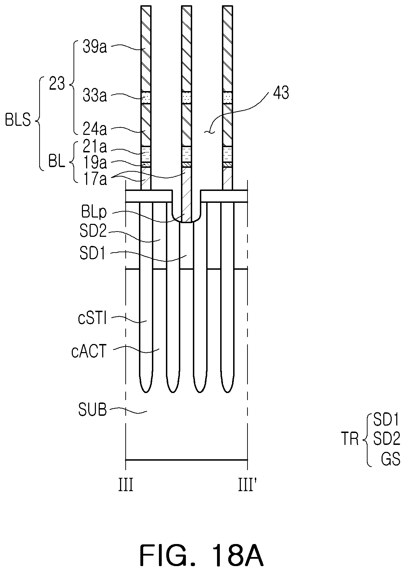

Referring back to FIGS. 1 to 3E, spacer structures SP_L and SP_U, contact plugs 75 and insulating fences may be formed within the openings (43 of FIGS. 17 and 18A to 18C). The insulating fences may be disposed between the contact plugs 75 arranged in the first direction (X). The spacer structures SP_L and SP_U may be formed on side surfaces of the opening (43 in FIGS. 17 and 18A to 18C). The spacer structures SP_L and SP_U may be formed on side surfaces of the bit line structures BLS and the insulating patterns 42.

The contact plugs 75 may include cell contact plugs 75c formed within the memory cell array region MCA and peripheral contact plugs 75d formed within the first and second extension areas EXTa and EXTb. The cell contact plugs 75c may be electrically connected to the second source/drain regions SD2, and the peripheral contact plugs 75d may be disposed on the peripheral device isolation region pSTI.

Bit line contact structures penetrating through the capping pattern 23 and electrically connected to the bit lines BL may be formed within the first and second extension regions EXTa and EXTb.

The bit line contact structures may be formed of the bit line contact structures of any one of the example embodiments of FIGS. 1 to 11. For example, it may be formed of the bit line contact structures 78 of FIGS. 1 to 3E.

Conductive patterns 80c and 80b and an insulating isolation pattern 83 may be formed. Forming the conductive patterns 80c and 80b and the insulating separation pattern 83 may include forming at least one conductive material layer, forming an opening exposing side surfaces of the conductive patterns 80c and 80b while forming the conductive patterns 80c and 80b by patterning the at least one conductive material layer, and forming the insulating isolation pattern 83 within the opening.

The conductive patterns 80c and 80b may include first conductive patterns 80c within the memory cell array region MCA and second conductive patterns 80b within the first and second extension regions EXTa and EXTb. The first conductive patterns 80c may be electrically connected to the cell contact plugs 75c on the cell contact plugs 75c. The second conductive patterns 80b may be electrically connected to the bit line contact structures 78 within the first and second extension regions EXTa and EXTb.

An etch stop layer 87 may be formed on the insulating isolation pattern 83 and the conductive patterns 80c and 80b.

A data storage structure DS may be formed (S50). The data storage structure DS may be formed within the memory cell array region MCA. The data storage structure DS may be formed of a capacitor including first electrodes 90 penetrating through the etch stop layer 87 and electrically connected to the first conductive patterns 80c, a dielectric layer 92 covering the first electrodes 90 and the etch stop layer 87, and a second electrode 94 on the dielectric layer 92.

As set forth above, according to some example embodiments of the present inventive concepts, an insulating pattern may be disposed at one end portion of end portions of a first bit line and a second bit line, which are adjacent to each other, and an insulating spacer, which is different from the insulating pattern, may be disposed at the other end portion. Such insulating patterns and insulating spacers may mitigate or prevent deformation of the first and second bit lines even when sizes of the first and second bit lines are reduced. Accordingly, the degree of integration of a semiconductor device may be increased and reliability of the semiconductor device may be improved.

The various and advantageous advantages and effects of the present inventive concepts are not limited to the above description, and may be more easily understood in the course of describing the specific example embodiments of the present inventive concepts. While some example embodiments have been shown and described above, it will be apparent to those skilled in the art that modifications and variations could be made without departing from the scope of the present inventive concepts, as defined by the appended claims.

## Claims

1. A semiconductor device, comprising:
a first bit line crossing a memory cell array region in a first direction, the first bit line extending into an extension region adjacent to the memory cell array region;
a second bit line crossing the memory cell array region in the first direction, the second bit line extending into the extension region and adjacent to the first bit line;
an insulating pattern within the extension region and contacting an end portion of the second bit line in the first direction; and
an insulating spacer within the extension region and contacting an end portion of the first bit line in the first direction, the insulating spacer being different from the insulating pattern.

2. The semiconductor device of claim 1, wherein the insulating pattern is spaced apart from the first bit line and the insulating spacer.

3. The semiconductor device of claim 1 or claim 2, wherein a length of the insulating pattern in the first direction is greater than a length of the insulating spacer in the first direction.

4. The semiconductor device of any preceding claim, wherein the insulating spacer includes a material different from a material of the insulating pattern.

5. The semiconductor device of any preceding claim, wherein within the extension region, a lower surface of the insulating pattern is at a lower level than lower surfaces of the first and second bit lines.

6. The semiconductor device of any preceding claim, wherein within the extension region, an upper surface of the insulating pattern is at a higher level than upper surfaces of the first and second bit lines.

7. The semiconductor device of any preceding claim, wherein
the insulating pattern includes a first portion extending in the first direction and a second portion extending from the first portion, the second portion having a width greater than a width of the first portion, and
the first portion of the insulating pattern is between the second portion of the insulating pattern and the second bit line.

8. The semiconductor device of claim 7, wherein within the extension region, the width of the second portion of the insulating pattern is greater than a width of each of the first and second bit lines.

9. The semiconductor device of any preceding claim, wherein
within the extension region, the insulating pattern includes a lower portion region at a lower level than the first and second bit lines, an intermediate region at a same level as the first and second bit lines, and an upper region at a higher level than the first and second bit lines, and
within the extension region, a width of a lower region of the insulating pattern is greater than a width of each of the first and second bit lines.

10. The semiconductor device of claim 9, wherein within the extension region, a maximum width of the intermediate region of the insulating pattern is greater than the width of each of the first and second bit lines.

11. The semiconductor device of any preceding claim, further comprising:
gate lines crossing the memory cell array region in a second direction perpendicular to the first direction, the gate lines being at a level different from the first and second bit lines,
wherein the gate lines include a dummy gate line adjacent to the extension region, and
a distance between the dummy gate line and the end portion of the first bit line within the extension region in the first direction is greater than a distance between the dummy gate line and the end portion of the second bit line within the extension region in the first direction.

12. The semiconductor device of claim 11, further comprising:
a substrate including the memory cell array region and the extension region;
a cell active region on the substrate and a cell device isolation region defining a side surface of the cell active region, the cell active region and the cell device isolation region being within the memory cell array region;
a peripheral device isolation region on the extension region; and
gate trenches crossing the cell active region and the cell device isolation region,
wherein the gate lines are in the gate trenches,
the first and second bit lines are on the cell active region, the cell device isolation region, and the peripheral device isolation region,
the insulating pattern is on the peripheral device isolation region, and
the first and second bit lines and the insulating pattern are within the extension region and on the peripheral device isolation region.
